# EUROPEAN PATENT APPLICATION

(11) **EP 2 260 995 A1**
(43) Date of publication of application: **15.12.2010**
(21) Application number: 09007796.7
(22) Date of filing: 12.06.2009
(51) Int. Cl.: B29C 33/42, B29C 41/00, B29C 41/20, G03F 7/00, B81C 99/00

(54) **Surface-structured polyurethane substrates and methods for producing the same**

(71) Applicant: Max-Planck-Gesellschaft zur Förderung der Wissenschaften E.V., 80539 München (DE)
(72) Inventor: Kruss, Sebastian, 77781 Biberach (DE); Spatz, Joachim, 70374 Stuttgart (DE); Martin, Raquel, Dr., 70569 Stuttgart (DE)
(74) Representative: Katzameyer, Michael

(57) **Abstract**

The present invention relates to surface-structured polymeric substrates comprising or consisting of polyurethane and having ordered surface structures in the nanometer range based on deposited nanoparticles as well as to a method for producing these substrates. Said method comprises the following steps:
(a) preparing a first precursor substrate that is nanostructured on at least one surface with inorganic nanoparticles,
(b) coating a hardenable substrate material for a second substrate different from the first precursor substrate material onto the nanostructured surface of the precursor substrate, which surface was obtained in step (a), and wherein the hardenable substrate material comprises cross-linkable monomeric, oligomeric or polymeric starting components for the production of a polymeric substrate, and
(c) hardening of the hardenable substrate material to obtain a polymeric substrate,
(d) separating the precursor substrate from the polymeric substrate from step (c), as a result of which a polymeric substrate nanostructured with nanoparticles is obtained, wherein the polymeric surface-structured substrate from step (d) comprises a polyurethane.

In a preferred embodiment of the invention, the nanoparticles are bonded to the surface of the polyurethane substrate without the use of a linker.

## Description

The present invention relates to surface-structured polymeric substrates comprising or consisting of polyurethane and having ordered surface structures in the nanometer range based on deposited nanoparticles as well as to a method for producing these substrates.

### Background

Periodically and aperiodically microstructured surfaces of a few micrometers to a few nanometers are used for a plurality of applications, especially electronic and optical components as well as sensors and in microtechnology. The production of such microstructured surfaces takes place by using known lithographic techniques suitably selected in accordance with the type of microstructure desired. Thus, e.g., structures in the nanometer range can be produced with electron-beam lithography and ion-beam lithography, and corresponding systems are commercially available. Furthermore, atomic-beam lithography allows large-surface periodic line patterns and different two-dimensional periodic structures to be produced by controlling the interactions of atomic beams with light masks.

However, since these methods have the disadvantage that they are not economically justifiable and/or supply no periodic structures in the nanometer range and/or can only be controlled by physical parameters and therefore require very expensive apparatuses, the so-called micellar block copolymer nanolithography was developed with which nanostructured surfaces with a periodicity in the lower nanometer range between 10 and 170 nm can be produced.

In this method, organic templates, e.g., block copolymers and graft copolymers that associate in suitable solvents to micellar core shell systems are used. These core shell structures serve to localize inorganic precursors from which inorganic particles with a controlled size can be deposited that are spatially separated from each other by the polymeric casing. The core shell systems or micelles can be applied as highly ordered monofilms on different substrates by simple deposition procedures such as spin casting or dip coating. The organic matrix is subsequently removed without residue by a gas-plasma process or by pyrolysis as a result of which inorganic nanoparticles are fixed on the substrate in the arrangement in which they were positioned by the organic template. The size of the inorganic nanoparticles is determined by the weighed portion of a given inorganic precursor compound and the lateral distance between the particles through the structure, especially by the molecular weight of the organic matrix. As a result, the substrates have inorganic nanoclusters or nanoparticles, such as gold particles, in ordered periodic patterns corresponding to the respective core shell system used deposited on their surface. This basic micellar block copolymer nanolithography method is described in detail in the following patents and patent applications: DE 199 52 018, DE 197 47 813, DE 297 47 815 and DE 197 47 816.

A prerequisite for this method is that the substrates consist of materials or material mixtures that withstand without damage the gas-plasma process or pyrolysis process required for removing the organic matrix. Therefore, customarily noble metals, oxidic glasses, monocrystalline or multicrystalline substrates, semiconductors, metals with or without passivated surface, insulators or in general substrates with a high resistance to subsequent etching procedures are used as substrates, whereas organic substrates and a plurality of inorganic substrates are to be excluded on account of their instability in said gas-plasma process or pyrolysis process. Moreover, substrates are excluded whose surface is not level enough to permit a regular self-organization of the polymeric micelles used to deposit the nanoclusters onto the substrate surface.

Since many organic polymeric substrates as well as the inorganic substrates that can not be used in the basic block copolymer nanolithography method have a great practical and economic significance, a method was developed which enables to transfer nanostructures from a first inorganic substrate to a second polymeric substrate. This method is described in detail in EP Patent Application No. 05 782 590.3.

However, the surface-structured substrates obtainable with this method and the method for producing the same have still some drawbacks with respect to the binding of the inorganic nanoclusters or nanoparticles to the polymeric substrate.

Typically, linker or binding molecules, such as propenethiol, alkylthioglycolate etc., are required to mediate the binding of the nanoparticles to the polymeric substrate, e.g. PEG, polystyrene etc. However, even in the presence of such linker molecules the binding affinity of the nanoparticles to some polymeric substrates is not suited for applications where a very high affinity is required. Moreover, the presence of such linker molecules generates a distance between the nanoparticles and the substrate surface and usually leads to an impairment or even partial destruction of the nanoparticle patterns and, therefore, is principally undesirable.

Thus, an object of the present invention is to provide polymeric substrates with a structured surface having inorganic nanoparticles in ordered pattern deposited thereon and exhibiting improved binding characteristics with respect to the binding of the nanoparticles to the polymeric substrate as well to provide an improved method for producing such nanostructured polymeric substrates.

Said object is achieved according to the present invention by the method according to claim 1 **characterized in that** polyurethane is used as the polymeric substrate and by the resulting polymeric substrate according to claim 9. Further aspects or preferred embodiments of the invention are the subject of the additional claims.

### Description of the invention

The method for producing a polymeric surface-structured substrate according to the invention comprises the following steps:
a) preparing a first precursor substrate that is nanostructured on at least one surface with inorganic nanoparticles,
b) coating a hardenable substrate material for a second substrate different from the first precursor substrate material onto the nanostructured surface of the precursor substrate, which surface was obtained in step (a), and wherein the hardenable substrate material comprises cross-linkable monomeric, oligomeric or polymeric starting components for the production of a polymeric substrate, and
c) hardening of the hardenable substrate material to obtain a polymeric substrate,
d) separating the precursor substrate from the polymeric substrate from step (c), as a result of which a polymeric substrate nanostructured with nanoparticles is obtained, wherein the polymeric surface-structured substrate from step (d) comprises a polyurethane.

Surprisingly it has been found that the use of polyurethane as the polymeric substrate enables to omit the use of linker molecules for binding the nanoparticles to the substrate surface and still to obtain a nanostructured surface with immobilized nanoparticles on said substrate which have a very high binding affinity to the polymeric substrate.

The absence of linker molecules is advantageous in that a possible impairment or partial destruction of the nanoparticle pattern due the linker molecules is avoided and the method of the invention for preparing a nanostructured polymeric surface can be effected faster, easier and less costly due to the omission of the linking step.

In the following the individual steps of the method for the production of a surface-structured polyurethane substrate of the present invention are explained in more detail.

In step (a) a first substrate surface nanostructured with inorganic nanoclusters or nanoparticles is produced.

The lithography methods known in the state of the art can be used to produce such nanostructured surfaces. The production with the micellar block copolymer nanolithography method with which nanostructured surfaces can be produced in a simple and economic manner is preferred (see e.g. DE 199 52 018, DE 197 47 813, DE 297 47 815 and DE 197 47 816.

If the nanostructured surface is produced by a lithography method known in the state of the art the first substrate used consists of a material that is customarily used in this lithography method. Particularly in the case of the micellar block copolymer nanolithography, the following substrate materials are typically used: noble metals, oxidic glasses, monocrystalline or multicrystalline substrates, semiconductors, metals with or without passivated surface, insulators or in general substrates with a high resistance to subsequent etching procedures. Some specific examples are Pt, Au, GaAs, AlₓGaAs, Si, SiO₂, Ge, SiₓN_{y}, SiₓGaAs, InP, InPsi, GaInAsP, glass, graphite, diamond, mica, SrTiO₃ as well as their doped modifications.

It is also possible that the first substrate consists of a surface-structured polymeric material which can be obtained by the method as described in EP Patent Application No. 05 782 590.3 or by the method of the present invention. The substrate obtainable in the method of the present application in step (d) can thus be used itself again as a first substrate in step (a). Principally, any structurable polymers can be used as the polymeric material. Some specific examples of the polymeric material disclosed in EP Patent Application No. 05 782 590.3 comprise polystyrene, epoxide resins, polydimethylsiloxane (PDMS) and polyethyleneglycoldiacrylates (PEG-DA).

The inorganic nanoparticles produced and applied to the first substrate surface in step (a) are in particular derived from oxygen-resistant noble metals such as Au, Pt, Pd or oxides such as, e.g., semiconductive oxides such as TiO₂, or magnetic particles such as, e.g., certain modifications of Fe₂O₃. Furthermore, clusters from metallic mixed systems such as Au/Fe₂O₃, AuCoO, Au/Co₃O₄, Au/ZnO, Au/TiO₂, Au/ZrO₂, Au/Al₂O₃, Au/In₂O₃, Pd/Al₂O₃, Pd/ZrO₂, Pt/Al₂O₃ and Pt/graphite are also conceivable. The inorganic nanoparticles from Au are preferred.

The nanoparticles obtained typically have diameters in the range of from 1 nm to 100 nm, preferably from 4 nm to 30 nm; The interparticle distances may be varied over a wide range as desired, for example in a range from 10 to 1000 nm, typically in the range from 15 to 250 nm.

The nanoparticles applied on the first substrate in step (a) may form clusters which are not limited in their form and can be present as points, lines, surfaces or any other forms. In the case of punctiform clusters, "size of the clusters" signifies the diameter. In the case of lines "size of the clusters" signifies the line width, wherein the length of the lines can be as desired. In the case of cluster surfaces the "cluster size" is a measure for the surface of the cluster. The following text simply refers to "nanoparticles" but it should be understood that this term is meant to encompass "nanoclusters" as defined above as well.

The obtained structures that are produced on the first substrate preferably have orders of magnitude from 1 nm to 300 µm. In the case of ordered structures they have periodicities of from 1 nm to 300 µm. As regards a cellular adhesion on a surface-structured substrate an order of magnitude or periodicity from 5 nm to 100 µm is especially preferred. An order of magnitude or periodicity from 5 nm to 100 nm is even more preferred and quite especially preferably 5 nm to 20 nm. An order of magnitude of 5 to 500 nm, in particular from 15 to 250 nm, can be produced, e.g., by the micellar block copolymer nanolithography method. Larger structures can be produced, e.g., by known photolithographic methods.

In step (b) of the method for producing a polymeric surface-structured substrate of the present invention a hardenable material for a second polyurethane substrate is applied onto the structured surface of the first substrate obtained in step (a).

The hardenable substrate material for the production of a polyurethane substrate may comprise any cross-linkable monomeric, oligomeric or polymeric starting components which are able to undergo a polymerization reaction, more specific a polyaddition, resulting in a polyurethane polymer under suitable hardening conditions.

According to a preferred embodiment, the starting components for the polymeric polyurethane substrate comprise a polyol monomer component which is selected from the group consisting of polypropylenglycols or polyethylenglycols of a desired molecular weight, typically of from 100 to 30,000, preferably in a range from 200 to 10,000, more preferably from 400 to 4000, e.g. PPG or PEG 400, 1000, 2000, 3000, 4000 etc., trioles such as glycerin, diol end-capped polymers such as poly(butadiene) adipates, or oligomeric and/or polymeric components derived therefrom. Polypropyleneglycols are especially preferred.

According to a further preferred embodiment, the starting components for the polymeric polyurethane substrate comprise an isocyanate monomer component which is selected from the group consisting of toluene diisocyanate (TDI), hexamethylenediisocyanate (HDI), 4,4'-methylenebis(phenylisocyanate) (MDI), isocyanate end-capped polymers such as diisocyanate end-capped poly(butadiene) adipates, or oligomeric and/or polymeric components derived therefrom. HDI, TDI and MDI are especially preferred.

The starting components may also comprise one or more chain extenders known in the art. Some specific non-limiting examples are N,N'-bis(2-hydroxyethyl)-2-aminoethanesulfonic acid (BES), butanediol, propanediol, polyamines or diamines such as ethylendiamine. BES is especially preferred.

The starting components are mixed and a (partial) polymerization/polyaddition is induced, typically by heating and, optionally, by adding a catalyst, e.g. selected from tertiary amines and tin compounds. Suitable catalysts and polymerization conditions will be recognized by a person skilled in the art of polymer chemistry. The skilled artisan will also recognize that for some starting components a catalyst will be dispensable. Some preferred embodiments are described in the Examples below.

Subsequently, the resulting hardenable material for the polyurethane substrate is applied uniformly with the desired thickness in the form of a prepolymer composition by a coating method customary in the state of the art. Suitable coating methods are for example simple dispensing of droplets, dip-coating, or spin-coating.

In step (c) the hardenable material is hardened for the second substrate. Typically, the hardening process is effected in a furnace at a temperature in a typical range of from 70°C to 200 °C and for a typical time period of from minutes to hours, preferably from about 30 minutes to about 10 h, in particular 1-6 h. The skilled artisan will recognize that the appropriate time period will depend on the temperature and catalyst used in each specific case. Other hardening methods known in the art for polyurethane polymers or prepolymers may also be applied.

After the hardening the polyurethane substrate may have a thickness of 1 µm to a few cm and a thickness of 10 µm to 10 mm is especially preferred. With regard to an application of the polyurethane surface-structured substrate as foil the second substrate according to step (c) preferably has a thickness of 10 nm to 1 cm, especially preferably 100 nm to 1 mm.

In step (d) of the method for the production of a surface-structured polyurethane substrate the first substrate is separated from the hardened polyurethane substrate and the nanoparticles. In this step, the nanoparticles are transferred to the second substrate with the same pattern that the nanoparticles had on the first substrate. The separation takes place in a suitable method either mechanically or by a separating agent that is suitably selected as a function of the nature of the first substrate material and taking into consideration the nature of the specific polyurethane substrate material. In the latter case, the separating agent has to be selected in such a manner that the first substrate is attacked by the separating agent, e.g., by dissolving, but inversely, the second polyurethane substrate is as stable and insensitive as possible to this separating agent. Some specific, but non-limiting separation methods are HF etching of glass, pulling off the PU mechanically after preincubation of the nanostructured precursor substrate with, e.g. fluorinated silanes which reduce PU attachment to the substrate and facilitate easy removal.

In a preferred embodiment of the invention, the nanoparticles of the nanostructured polyurethane substrate are arranged in a mean interparticle distance of from 10 nm to 300 nm, preferably of from 15 nm to 250 nm, typically in a hexagonal arrangement.

The successful transfer of gold nanostructures of varying density from a first precursor substrate to different PU substrates can be demonstrated by several methods, such as plasmon resonance, SEM, AFM and TEM micrographs. Each method can tackle a different specific aspect of the transfer.

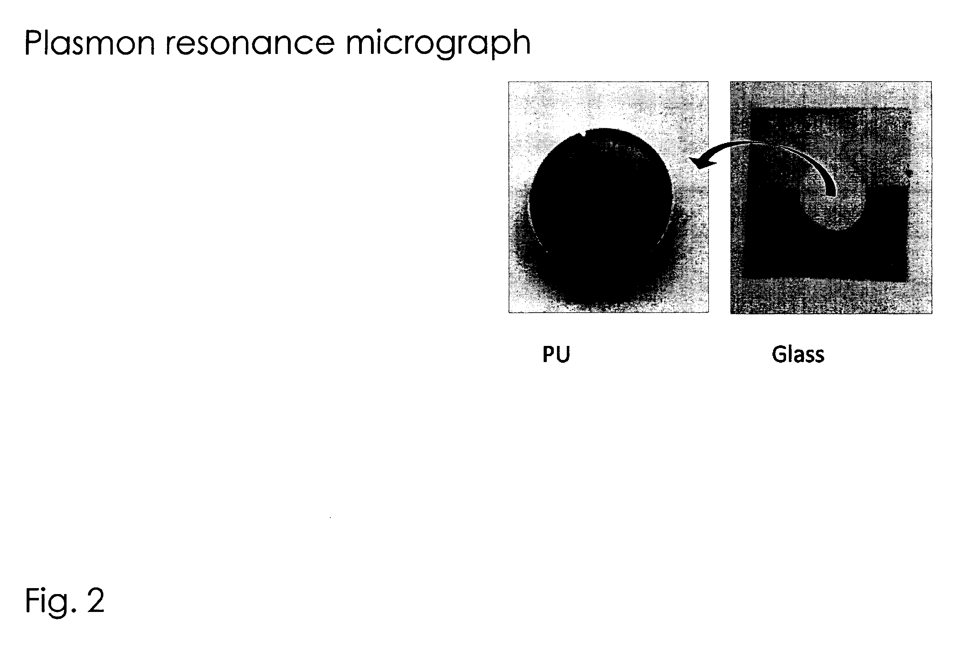

In particular, visualization of plasmon resonance can be used to show that gold particles are transferred and are chemically accessible in large areas. Gold nanoparticles have special optic properties but are usually difficult to observe without high resolution methods. Gold dots can be enlarged via electroless deposition leading to different optical properties. After this process areas with nanostructures are detectable by the naked eye or a microscope. It has been demonstrated that at least the majority of gold particles had been transferred (Fig. 2).

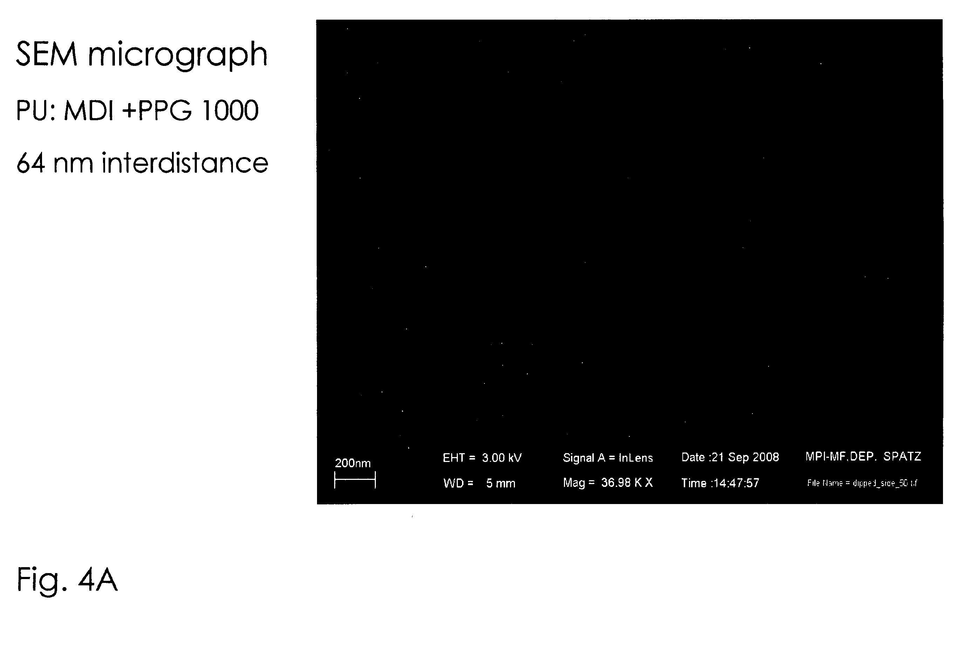

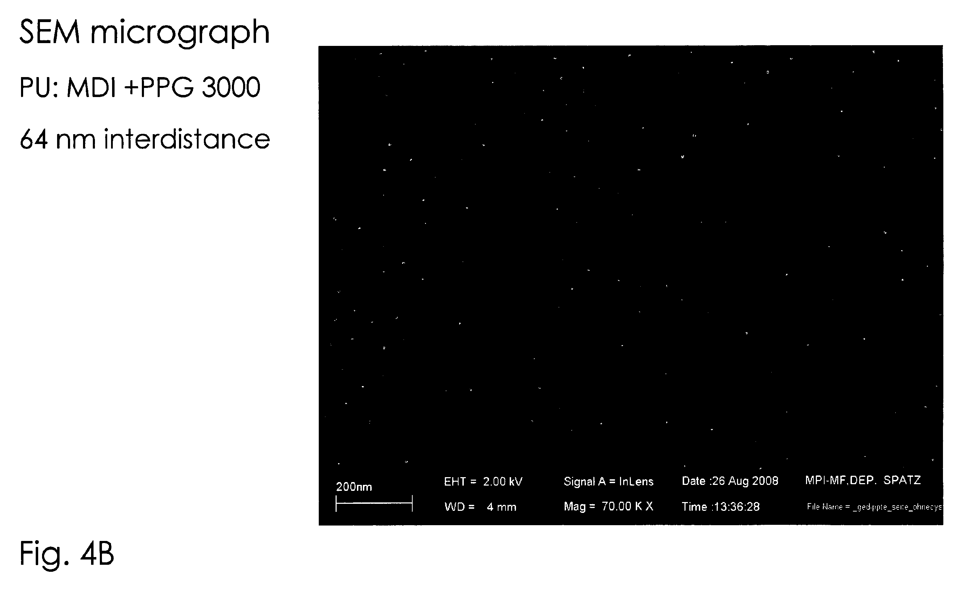

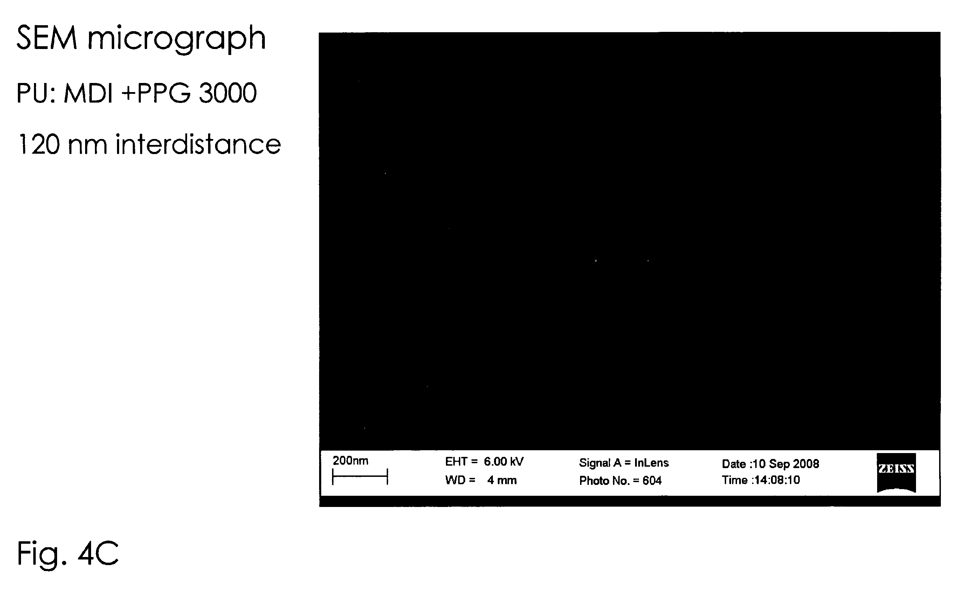

Scanning electron microscopy (SEM) can verify that gold particles are transferred and that the order of the primary substrate remains. This was shown for different polyurethane compositions and different interparticle distances (Figs. 4-6).

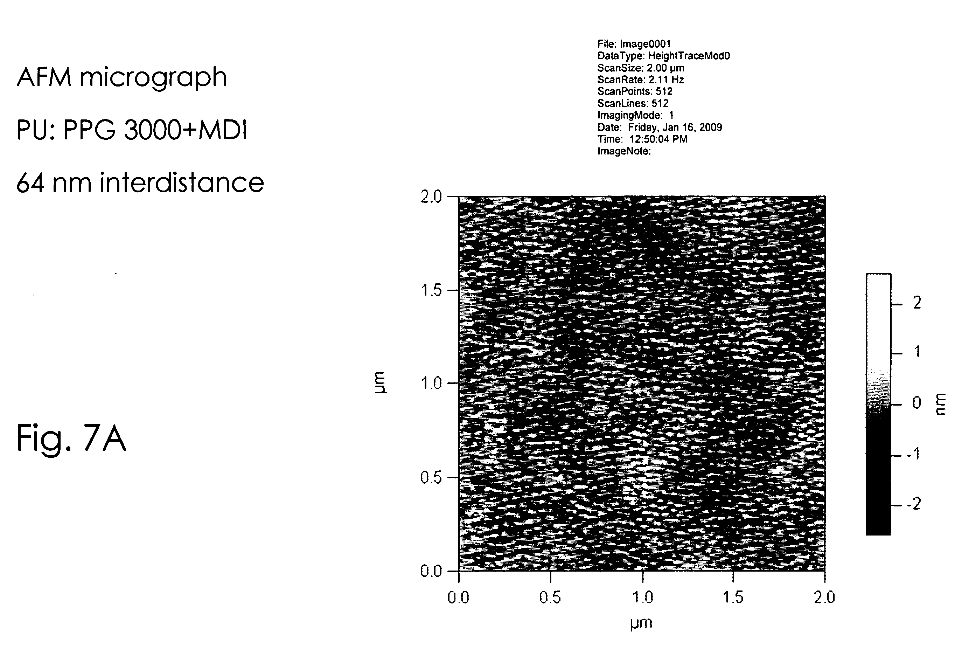

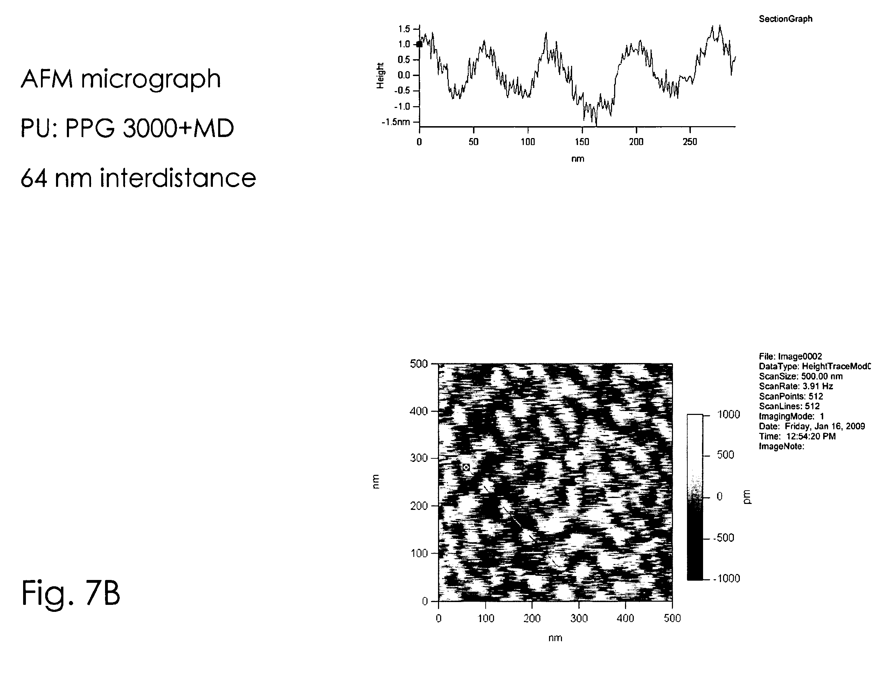

Atomic force microscopy (AFM) can show that the gold dots are transferred and are mechanically accessible. The latter feature is important to ensure that potential binding or reaction partners, e.g. cells, can recognize ligands, e.g. biomolecules, which are immobilized on gold dots. It has been demonstrated that the gold nanoparticles on PU samples were mechanically accessible and had an accessible height of 1.5 nm (Fig. 7).

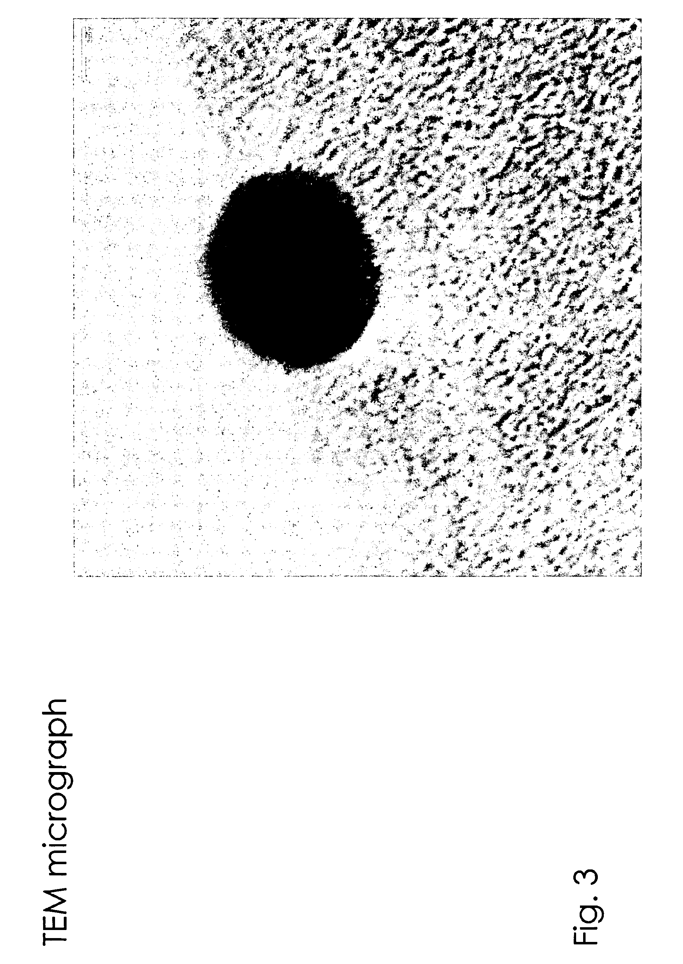

Transmission electron microscopy (TEM) can be used to observe single gold dots. This allows the measurement of gold dot size and their crystal properties. It was shown that the particles of the samples were spherical, crystalline and had a diameter of typically about 6 nm (Fig. 3).

Summarizing, the density of the gold nanoparticles on the PU surface can be adjusted freely.

Generally, the nanoparticles rise above the surface of the PU substrate, preferably about 0.5 to 3 nm, more specifically about 1.5 nm. This feature allows a better access to the nanoparticles and, thus, is favourable for several applications, in particular such which involve further interactions of the nanoparticles with binding partners or other materials. Contrary to this, in nanostructured PEG hydrogels as described in EP 05 782 590.3, the nanoparticles appear to be located below the substrate surface.

The gold nanoparticles obtained on the PU substrate of the invention can be used as catalysts for directed growth of secondary structures. More specifically, electroless deposition(EDP)can be used to enlarge the gold dots or to grow a second material on top of the gold dots. The crystalline nature of the gold particle triggers the preferred deposition of metal atoms on the gold nanostructures and not between them. In a more specific case silver/gold hybrid particles are fabricated (see Example 2 for details). Silver could be interesting for biomedical applications due to its antimicrobial properties.

It should be noted that such secondary structures and hybrid particles can be produced not only on PU but also on a variety of different gold-nanostructured surfaces, e.g. metallic or polymeric surfaces (in particular hydrogels), glass etc., including the substrates listed on page 6, second and third paragraph, of the present application.

As already mentioned above, the nanoparticles of the polyurethane substrate are bound to the substrate surface with a very high affinity even in the absence of linker molecules. In particular, it has been demonstrated (see Example 4 below) that the nanoparticles remain immobilized when subjected to conditions typically used for removing particles from substrate surfaces, such as sonication, sonication + cystamine treatment or cell treatment (at least 24 h at 37°C). For comparison, a sonication + cysteamin treatment as indicated in Example 4 removes all gold nanoparticles from a glass surface.

The size of the polyurethane substrate having a structured surface is not critical and may be between 100 nm² and several meters, in accordance with the desired usage. A size of 1 mm² to 100 cm² is preferred.

As mentioned above, the use of linker molecules for binding the nanoparticles to the polyurethane substrate is not necessary and may be even disadvantageous for a number of applications. However, in a few cases it may be desirable to have at least a part of the nanoparticles bound to the polyurethane substrate by linker molecules. Suitable linker molecules are for example bifunctionalized molecules having a thiol functional group and an amine/hydroxyl functional group. Some specific, non-limiting examples are cystamine, mercaptoethanol and structurally related compounds. The binding molecule should be selected in such a manner that it can be bound specifically to the inorganic nanoclusters and bonds chemically or electrostatically to the second substrate but does not adhere to the first substrate.

The immobilization of the binding molecules takes place with known methods. For example, the binding to gold clusters can take place in the gas phase. Preferably, mercaptoethanol or other binding molecules are bound in solution within a reaction time of a few hours or even 1-2 days to gold clusters.

According to a preferred embodiment of the invention, a passivation of the areas surrounding the nanoparticles or nanoclusters can be carried out following step (d) in order to achieve a targeted interaction of, e.g., cells or other biomolecules with the inorganic nanoparticles and/or to prevent unspecific adhesion of proteins or other substances. Such a passivation by polyethyleneglycol is described, e.g., in US Patent Application 2003/0133963 A1 by J.A. Hubbell. Alternatively, passivation may be obtained by tethering of a Zr complex and subsequent functionalizing with short PEG molecules (Dennes and Schwartz, Controlling of cell adhesion on polyurethanes, Soft Matter, 2008, 4, 86-89). A still further approach involves the use of BES or similar bi- or multifunctional compounds having a sulfonic acid group which imparts the desired passivating properties and a second functional group, e.g. an amino, hydroxyl or isocyanato group, which enables covalent (or non-covalent) integration to into the polymer during the polyaddition reaction. The latter method is especially advantageous in that no post-treatment step is necessary. Preferably, BES or an alternative compound is added during the last third of the prepolymerisation period. The BES or alternative compound may be added in solid form (powder) with vigorous agitating or dissolved in an appropriate solvent.

After step (d) of the separation of the first substrate and, if necessary, after the above-described passivation, a step of biofunctionalizing the inorganic nanoparticles can be carried out. "Biofunctionalization" designates a step in which specific molecules are applied on the nanoparticles in order to functionalize them for certain biological applications.

All proteins, protein sequences, nucleic acids and other molecules that are of biological interest may be considered for this purpose. These molecules can be adhered to the nanoclusters directly or via different binding molecules. A cyclic RGD peptide with thiol anchor can be bound, e.g., to the gold clusters after the passivation step. The gold clusters can be functionalized in this manner for the specific binding of integrins, a cellular adhesion protein. Another example is the binding of molecular motors such as kinesin or myosin.

According to a further preferred embodiment the polyurethane substrate material can be functionalized before or, preferably, after the hardening with heterobifunctional molecules for the binding of further molecules. The heterobifunctional molecule is constructed in such a manner that it has at least two different functional groups. At least one of these functional groups is such that it can bind to the hardenable material of the second substrate while the chemical functionality of the other functional group(s) remains preserved even after the binding. For example, the remaining free functional group may be an amino group of carboxyl group. The heterobifunctional molecule may also contain both kind of functional groups, e.g. an amino acid such as aspartate or glutamate. These groups can be further functionalized with desired ligands by means of standard coupling chemistry.

Another approach involves a further functionalizing of surface urethane groups using e.g., bromoalkylation (Levy et al., Biomacromolecules 2006, 7, 317-322) and subsequent nucleophilic substitution of the bromine by thiols, (e.g. RGD derivatives), amines or nucleophilic O-containing compounds, or by tethering of a Zr complex (Dennes and Schwartz above) and further coupling of said complex with e.g. molecules having carboxyl groups or RGD derivatives.

Thus, e.g., a biofunctionalization of the remaining substrate surface can be carried out with any biologically interesting molecules in addition to the biofunctionalization of the nanostructure. In this connection growth factors such as EGF, NGF and TGF as well as cellular adhesion proteins and/or peptides such as fibronectin, RGD and catherines as well as extracellular signal molecules such as vasopressin, interferon, insulin are especially interesting here. Molecules of different types can be fixed adjacent to each other in an ordered manner with such a functionalization, so that they enter into a regulated interaction with each other.

Another advantageous embodiment is the use of three-dimensional first substrates. This three-dimensional first substrate is entirely or partially nanostructured on the surface. In step (b) this substrate is entirely or partially embedded in the hardenable material and dissolved out in step (d) so that a three-dimensional structure nanostructured on the surface is obtained. The three-dimensional first substrate can have any three-dimensional form, e.g., a fibrous, spherical or lens-shaped form. For example, the three-dimensional first substrate can be a glass fiber with a diameter of 5 µm to 300 µm whose surfaces are coated with the above-named method with a nanostructure of gold clusters. Colloids coated with gold points are also conceivable. The gold points are activated by the immobilization of cysteamine and acryloylchloride and cast into PEG-DA. The glass fibers can be dissolved out in step (d) with hydrofluoric acid or separated mechanically. Specific activation for the binding of certain cells makes possible a use as nerve canal or stent.

The nanostructured polyurethane substrate obtained as outlined above may be used for producing a polymeric article comprising a plurality of nanoparticles, in particular in a predetermined specific geometric arrangement, on a polymeric substrate comprising or consisting of polyurethane. Such an article represents a further aspect of the present invention.

The polyurethane substrate with nanostructured surfaces obtainable from the above-described method in accordance with the invention and/or a polymeric article produced therefrom are especially suited for use in medical applications and devices such as implant materials, stent materials and endoscopic devices. For example, the high binding affinity of the nanoparticles bound to the PU surface ensures that the nanoparticles remain bound the substrate surface even in the course of long-term applications such as permanent implants etc. The nanostructured PU substrates may also be advantageous for such applications as wound dressings.

The micromorphology of the surface-structured PU substrate can be controlled by the kind, density and pattern of the nanoparticles deposited thereon. This enables a fine-tuning of various surface properties such as biocompatibility, roughness and stability and can be utilized, e.g., to obtain a better adhesion behaviour of endothelial cells or a better haemocompatibility, in particular reduced thrombogenicity of materials comprising such a surface.

Another preferred use of the nanostructured polyurethane substrate or of the polymeric article produced therefrom is the selective binding of target molecules or target cells. For example, the nanoparticles may serve as anchor points to immobilize biomolecules, e.g. antibodies.

Furthermore, PU substrates with nanostructured surfaces and obtainable with the method in accordance with the invention are interesting for rather different usages in which biological systems are imitated, manipulated, examined and quantified via a precise arrangement of biologically active molecules, e.g., the imitation of interactions of viruses or pollen with cells, the manipulation of cell differentiation to desired phenotypes and the binding of molecular motors in order to examine and quantify their activities. Specifically receptors and the proteins in the cell can be arranged and positioned via the geometry and chemical and physical nature of the structured surface on which a cell can adhere in such a manner that the function of the cell, e.g., the activity of biochemical signal paths, gene expression and the synthesis of certain cellular proteins can be purposefully controlled by this.

Furthermore, such nanostructured substrates and articles may also be used for electronic and optical components as well as for biological or chemical sensors. For example, the surface plasmon resonance of the gold nanoparticles varies in dependency from the molecular environment and this effect may be advantageously used for sensors.

### Figures

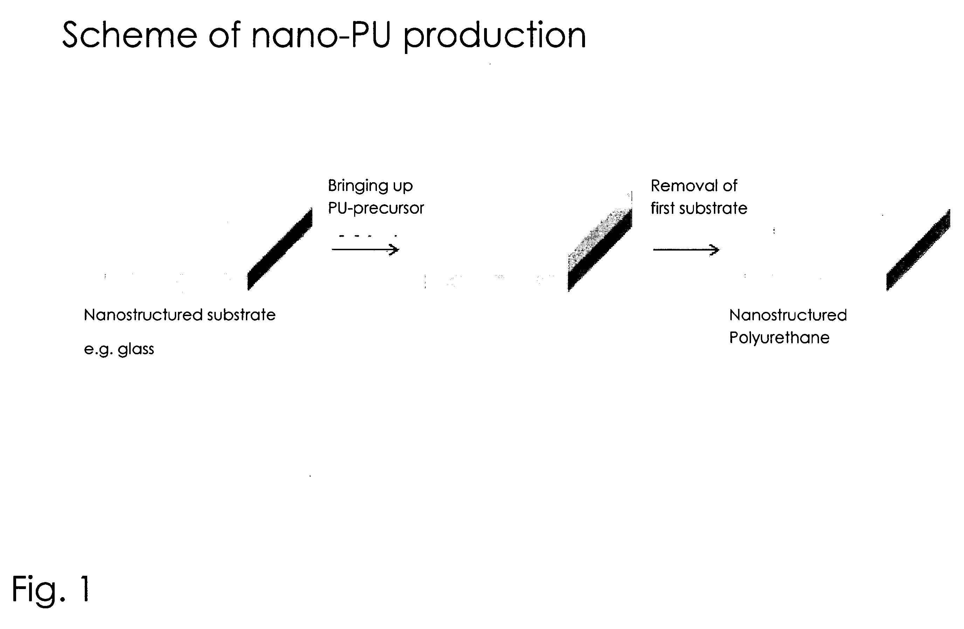

**Fig. 1** General scheme for the production of nanostructured PU-substrates
**Fig. 2** Plasmon resonance micrographs of the initial nanostructured glass substrate and the PU substrate of the invention
**Fig. 3** TEM micrograph of a gold nanoparticle on the PU substrate of the invention
**Fig. 4A-4C** SEM micrographs of PU substrates of the invention with different interparticle distances and monomers
**Fig. 5A** and **5B** Stability of the nanostructure after treatment with ultrasound (A) and ultrasound + 1% cystamine (B)
**Fig. 6** Stability of the nanostructure after incubation with fibroblast cells
**Figs. 7A** and **7B** AFM micrographs of the nanostructured PU substrate with different interparticle distances

The present invention is illustrated in more detail in the following non-limiting examples.

### EXAMPLE 1

### Transfer of gold structures from a glass surface onto polyurethane

Nanostructured glass surfaces (first substrate) were prepared by block copolymer micelle nanolithography (BCML) as described in the prior art, e.g. in DE 199 52 018, DE 197 47 813 and Spatz et al., Langmuir 2000, 16, 407.

250 mg MDI (4,4'-methylenbis(phenylisocyanate)) is stirred with 2 ml polypropyleneglycol 3000 at 90°C under vacuum. After 10 minutes 10 µl triethylamine are added under nitrogen to produce a PU precursor. Then one droplet of the PU precursor is put on a gold-nanostructured plasma-activated first substrate as prepared above. Afterwards a curing process of 6 h at temperatures from 90-130 °C finishes the polyaddition reaction. Mechanical peeling off or HF etching removes the first substrate and releases a nanostructured polyurethane.

Similar reactions may be conduced with different monomers/isocyanates, polyols and chain extenders. The specific reaction conditions for optimal results in each case can be adjusted by a person skilled in the art with routine experiments.

### EXAMPLE 2

### Electroless deposition

For the electroless deposition of gold on PU substrates with gold nanodots a modified protocol of Lohmueller et al. (Adv. Mat. 2008, 20, 2297-2302) was used. Specifically, a 0.1 % HAuCl₄x3H₂O/water solution was prepared. The reducing agent was 5 mM hydroxylamine/HCl in water. First, 100 µl of the gold-acid solution was added to the PU substrate stored in 2 ml water in a small Petri dish. Then 100 µl of the hydroxylamine solution was added. After 30 s areas with gold dots are clearly visible. Samples are then removed out of the solution and washed in water. If desired, photographs can be taken with a standard digital camera.

Electroless deposition(EDP) can also be used to grow a second material on top of the gold dots. The crystalline nature of the gold particle triggers the preferred deposition of metal atoms on the gold nanostructures and not between them.

In a specific embodiment of the invention, an adapted recipe of Tollens reagent(AgN03, NaOH, NH3 and water) was used to achieve electroless deposition of Ag on gold nanodots. In this case Glucose dissolved in water reduces the silver ions. In short the surface is covered by a mixture of Tollens reagent and the reducing agent. Reaction kinetics are mainly determined by the amount of reducing agent and reaction time. Reaction times are between 1 s and several minutes depending on these two parameters. By changing these parameters, diameters of gold/silver-hybrid particles can be tuned up to 40 nm. This recipe can be used on different gold-nanostructured surfaces (PU, hydrogels and other polymers, glass, etc.).

### EXAMPLE 3

### Transmission electron microscopy (TEM) of nanostructured polyurethane surfaces

For TEM investigations a JEOL 400 FX system was used. The acceleration voltage applied was 400 kV. A 2k*2k CCD chip (Orius Sc 200) manufactured by GATAN digitalized the pictures.

In Fig. 3 a TEM micrograph of a gold nanoparticle on a PU surface is shown. The scale bar corresponds to 2 nm. The diameter of the particle is about 6 nm. The micrograph shows the crystalline nature and its spherical geometry. The material below the particle is PU.

### EXAMPLE 4

### Scanning electron microscopy (SEM) of nanostructured polyurethane surfaces

For the SEM micrographs a Zeiss Ultra 55 SEM was used. Samples were graphite-sputtered with a BALTEC Med 020 Coating System to avoid eletric charging. Acceleration voltages for image acquisition with the In Lens detector were between 2 kV and 6 kV.

Figs. 4A-C present SEM micrographs of PU substrates of the invention with different interparticle distances (64 nm interdistance and 120 nm interdistance, respectively) and different monomers (MDI and PPG 1000 in Fig. 4A; MDI and PPG 3000 in Figs. 4B and 4C).

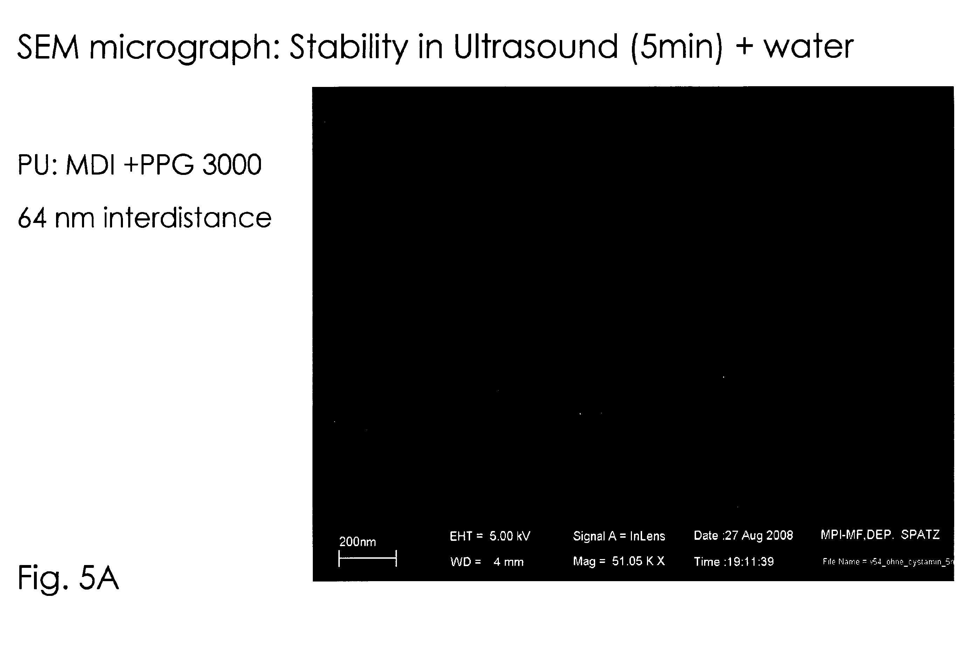

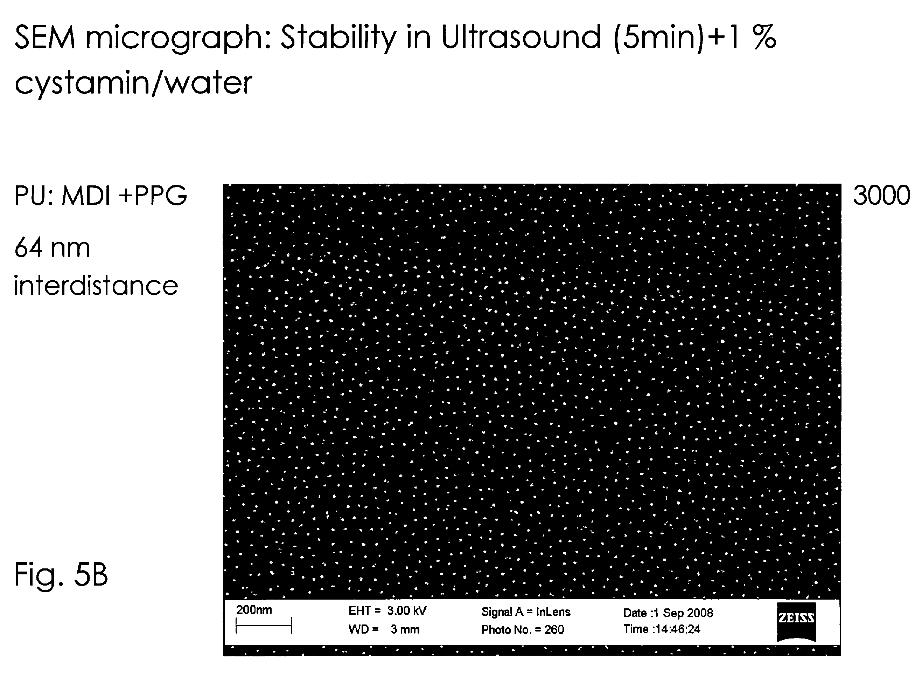

Fig. 5A and 5B demonstrate the stability of the nanostructure after treatment in a standard ultrasound bath in water at 30°C for 5 minutes with only ultrasound (A) and ultrasound + 1% cystamine in water (B).

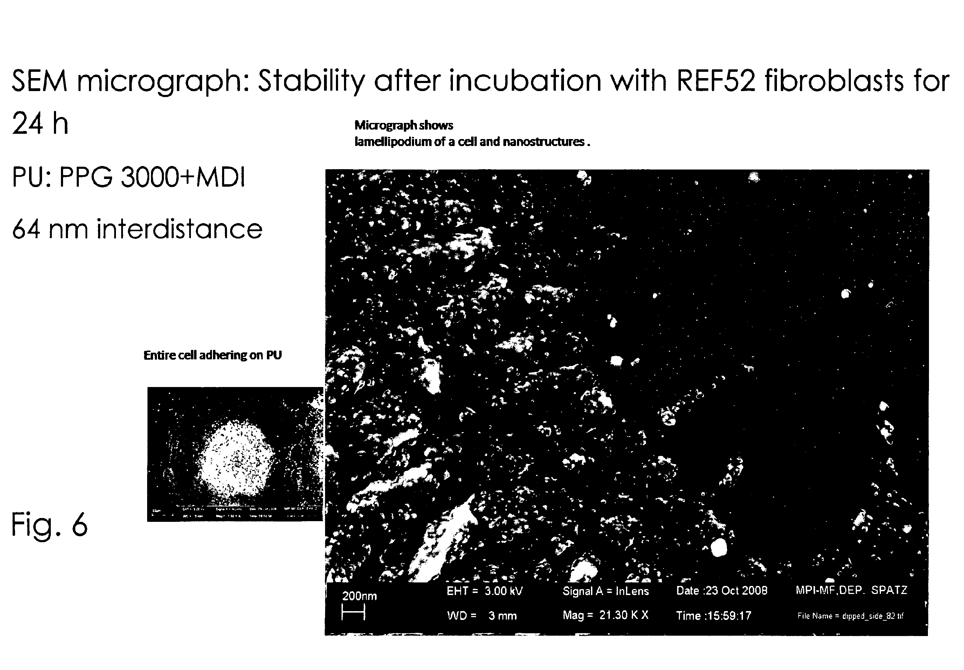

Fig. 6 demonstrates the stability of the nanostructure after incubation with REF-52 fibroblast cells for 24 h at 37°C in 1% FBS/DMEM cell culture medium.

In this case, before imaging cells on PU surfaces with electron microscopy samples have to be prepared for vacuum conditions. In short, cells adhering on the PU surface were fixed with 4% paraformaldehyde. The water inside the cells was exchanged by ethanol (dilution series). Finally ethanol was exchanged by carbon dioxide in a critical point dryer.

Summarizing, the SEM data prove:
Gold dots are completely transferred onto PU surfaces;
composition and interdistance can be changed individually;
gold dots are stable under harsh conditions; e.g. cystamine treatment (on glass this leads to a complete lift off of gold particles);
cells adhering to the PU surface don't impair the nanoparticles which is essential for biomedical applications and represents one important advantage of the present method.

### EXAMPLE 5

### Atomic force microscopy (AFM) of nanostructured polyurethane surfaces

Atomic force microscopy was carried out with an Asylum Research AFM operating in tapping mode in air under ambient conditions. The oscillation frequency was set to roughly 300 kHz depending on the Si cantilever (k ∼ 42 N/m).

Figs. 7A and 7B show AFM micrographs of a nanostructured PU substrate as well as a graphic representation of the heights of the gold dots. In particular, Fig. 7A shows a scan over a large area. As evident from the scale, the particles rise above the substrate surface and show a regular quasi-hexagonal pattern over large areas. Fig. 7B shows a smaller area. In the lower picture, a straight line has been laid through several gold dots and the corresponding height histogram of this line (shown above) enables to assess how far the particles extend from the surface.

The micrographs prove that gold dots are transferred, mechanically accessible and are rising above the surface (about 1.5 nm). The distances between individual particles correspond to those observed by SEM.

## Claims

1. A method for producing a polymeric surface-structured substrate, comprising the steps:
(a) preparing a first precursor substrate that is nanostructured on at least one surface with inorganic nanoparticles,
(b) coating a hardenable substrate material for a second substrate different from the first precursor substrate material onto the nanostructured surface of the precursor substrate, which surface was obtained in step (a), and wherein the hardenable substrate material comprises cross-linkable monomeric, oligomeric or polymeric starting components for the production of a polymeric substrate, and
(c) hardening of the hardenable substrate material to obtain a polymeric substrate,
(d) separating the precursor substrate from the polymeric substrate from step (c), as a result of which a polymeric substrate nanostructured with nanoparticles is obtained,
wherein the polymeric surface-structured substrate from step (d) comprises a polyurethane.

2. The method according to claim 1, wherein the nanoparticles are bonded to the surface of the polyurethane substrate without the use of a linker.

3. The method according to claim 1 or 2 wherein the starting components for the polymeric substrate comprise a polyol monomer component, selected from the group consisting of polypropylenglycols or polyethylenglycols in a molecular weight range of from 100 to 30,000, trioles such as glycerin, diol end-capped polymers such as poly-(butadiene) adipates, and an isocyanate monomer component, selected from the group consisting of which is selected from the group consisting of toluene diisocyanate (TDI), hexamethylenediisocyanate (HDI), 4,4'-methylene-bis(phenylisocyanate) (MDI), isocyanate end-capped polymers such as diisocyanate end-capped poly(butadiene) adipates, or oligomeric and/or polymeric components derived therefrom.

4. The method according to any one of the preceding claims wherein the nanoparticles comprise gold nanoparticles, silver nanoparticles or silver nanoparticles with a gold core.

5. The method according to any one of the preceding claims wherein the nanoparticles rise above the surface of the substrate.

6. The method according to any one of the preceding claims wherein the precursor substrate has a 3-dimensional form.

7. The method according to any one of the preceding claims wherein the nanoparticles are arranged in a mean interparticle distance of from 1 nm to 300 nm, preferably of from 15 nm to 250 nm.

8. The method according to any one of the preceding claims comprising one more additional steps which comprise:
- a surface treatment of the structured polymeric substrate, e.g. functionalization of the nanoparticles, elecroless deposition of a metal onto the nanoparticles, and/or
- passivating surface areas devoid of nanoparticles.

9. A polymeric substrate comprising or consisting of polyurethane having a surface nanostructured with nanoparticles, obtainable by the method according to any one of the preceding claims.

10. The polymeric substrate according to claim 9, wherein the nanoparticles are immobilized on the polymeric substrate and remain immobilized when subjected to conditions of sonification or sonification in combination with a cystamine treatment which are sufficient to remove the same nanoparticles from a glass surface.

11. The use of the polymeric substrate according to claim 9 or 10 for producing a polymeric article.

12. A polymeric article, comprising a plurality of nanoparticles, in particular in a predetermined specific geometric arrangement, on a polymeric substrate comprising or consisting of polyurethane.

13. An implant, in particular a permanent implant, which comprises a polymeric article according to claim 12.

14. The use of the polymeric substrate according to claim 9 or of the polymeric article according to claim 12 as a component of an implant, as a component of a medical device, in particular of an endoscopic device, a wound dressing, or a component of a biological or chemical sensor.

15. The use of the polymeric substrate according to claim 9 or of the polymeric article according to claim 12 for the selective binding of target molecules or target cells.
